# EUROPÄISCHE PATENTSCHRIFT

(11) **EP 2 361 322 B1**
(45) Veröffentlichungstag und Bekanntmachung des Hinweises auf die Patenterteilung: **10.05.2017**
(21) Anmeldenummer: 09756153.4
(22) Anmeldetag: 13.11.2009
(51) Int. Cl.: C23C 16/24, C30B 29/04, C30B 29/06, C23C 16/44, H01L 21/67, C23C 16/27

(54) **VORRICHTUNG UND VERFAHREN ZUM BESCHICHTEN EINES SUBSTRATS MITTELS CVD**
DEVICE AND METHOD FOR COATING A SUBSTRATE USING CVD
DISPOSITIF ET PROCÉDÉ POUR REVÊTIR UN SUBSTRAT PAR DÉPÔT CHIMIQUE EN PHASE VAPEUR

(30) Priorität: 24.11.2008 DE 102008044028
(43) Veröffentlichungstag der Anmeldung: 31.08.2011
(73) Patentinhaber: DIACCON GmbH, 90762 Fürth (DE); CemeCon AG, 52146 Würselen (DE)
(72) Erfinder: RÜFFER, Martin, 92224 Amberg (DE); ROSIWAL, Stefan, 96049 Bamberg (DE); BAREISS, Christian, 52070 Aachen (DE); REICHERT, Walter, 52064 Aachen (DE); LEMMER, Oliver, 52066 Aachen (DE); PERLE, Marc, 91301 Forchheim (DE)
(74) Vertreter: Dr. Gassner & Partner mbB
(86) Internationale Anmeldenummer: PCT/EP2009/065176
(87) Internationale Veröffentlichungsnummer: WO 2010/057836

(56) Entgegenhaltungen:
- EP-A1- 0 470 447
- EP-A1- 0 714 997
- WO-A1-02/068709
- WO-A1-2008/003275
- US-A- 5 314 570
- US-B1- 6 582 780

## Beschreibung

Die Erfindung betrifft eine Vorrichtung nach dem Oberbegriff des Anspruchs 1 sowie ein Verfahren unter Verwendung der Vorrichtung.

Eine solche Vorrichtung ist aus der JP 01072992 A bekannt. Dabei sind die Heizleiter waagerecht oberhalb des zu beschichtenden Substrats angeordnet. Zur Erzeugung einer geeigneten Spannkraft sind die Heizleiter über eine Umlenkeinrichtung geführt und an ihrem einen Ende mit einem Gewicht versehen. Die nach dem Stand der Technik bekannte Vorrichtung hat den Nachteil, dass die Heizleiter bereits nach ein oder zwei Beschichtungsvorgängen brechen und infolgedessen unbrauchbar werden. Es ist in der Praxis erforderlich, die Heizleiter nach jedem Beschichtungsvorgang auszutauschen. Das erfordert einen hohen Zeit- und Kostenaufwand.Weitere, verwandte Vorrichtungen sind aus der WO 02/068709 A1 und der US 6 582 780 B1 bekannt.

Zur Behebung des vorgenannten Nachteils ist es zwar denkbar, relativ dicke Heizleiter mit einem Durchmesser von etwa 2 mm zu verwenden. Die Verwendung solcher relativ dicken Heizleiter ist aber ebenfalls nachteilig. Dicke Heizleiter erzeugen im Gegensatz zu dünnen Heizleitern eine relativ große Wärmestrahlung, welche unerwünschterweise auf die Substrate einwirkt. Abgesehen davon wird zum Beheizen dicker Heizdrähte eine erheblich höhere elektrische Leistung benötigt.

Aufgabe der Erfindung ist es, die Nachteile nach dem Stand der Technik zu beseitigen. Es soll insbesondere eine Vorrichtung angegeben werden, welche ein mehrfaches Beschichten von Substraten ohne einen Austausch der Heizleiter ermöglicht.

Nach einem weiteren Ziel der Erfindung soll dabei die eingesetzte elektrische Leistung möglichst gering sein. Eine weitere Aufgabe der Erfindung ist die Angabe eines möglichst effizienten Verfahrens zur Beschichtung eines Substrats mittels CVD.

Diese Aufgabe wird durch die Merkmale der Ansprüche 1 und 16 gelöst. Zweckmäßige Ausgestaltungen der Erfindung ergeben sich aus den Merkmalen der Ansprüche 2 bis 15 und 17 . Nach Maßgabe der Erfindung ist vorgesehen, dass das Gewicht oder der Heizleiter an der zweiten Elektrode unter Ausbildung eines elektrischen Schleifkontakts so geführt ist, dass ein Vektor der durch das Gewicht erzeugten Gewichtskraft mit einer Richtung der Längserstreckung des Heizleiters einen Winkel von 0 bis 35° bildet. - Damit gelingt es überraschenderweise, auch bei der Verwendung dünner Heizleiter deren Haltbarkeit drastisch zu erhöhen. Indem zwischen dem Heizleiter und der zweiten Elektrode ein elektrischer Schleifkontakt vorgesehen ist, können thermisch bedingte Längenänderung des Heizleiters beim Aufheizen und Abkühlen kompensiert werden. Die durch das Gewicht erzeugte Gewichtskraft wirkt erfindungsgemäß im Wesentlichen in Richtung der Längserstreckung des Heizleiters. D. h. die durch das Gewicht hervorgerufene Spannkraft wird auf den Heizleiter nicht über eine starke Umbiegung ausgeübt. Es hat sich gezeigt, dass insbesondere auch die Ausrichtung der Gewichtskraft etwa mit der Richtung der Längserstreckung des Heizleiters erheblich zu dessen verbesserter Haltbarkeit beiträgt. - Die erfindungsgemäße Vorrichtung gewährleistet, dass die Heizleiter stets straff und exakt, insbesondere exakt parallel, gehalten werden. Auch nach einer Vielzahl von Betriebszyklen hängen die Heizleiter nicht durch. Deren Abstand zum beschichtenden Substrat kann über eine Vielzahl von Beschichtungsvorgängen hinweg stets reproduzierbar konstant gehalten werden.

Nach einer vorteilhaften Ausgestaltung wird eine den Heizleiter oder das Gewicht gegen die zweite Elektrode zwingende Kontaktkraft durch das Gewicht hervorgerufen. Das kann auf besonders einfache Weise erreicht werden, indem die Richtung der Längserstreckung der Heizleiter mit der zweiten Elektrode geringfügig gegen die Vertikalrichtung verstellt wird. In diesem Fall steht ein Vektor der auf den zwischen den beiden Elektroden gespannten Heizleiter wirkenden Spannkraft schräg auf dem Vektor der Gewichtskraft. Die Spannkraft bildet hier die Resultierende aus Gewichtskraft und Kontaktkraft.

Nach einer vorteilhaften Ausgestaltung liegen das Gewicht oder der Heizleiter gleitverschiebbar an einer Innenwand einer an der zweiten Elektrode vorgesehenen Ausnehmung an. Bei der Ausnehmung kann es sich beispielsweise um eine schlitzartige Ausnehmung handeln, in welcher der Heizleiter geführt ist. Zweckmäßigerweise weist die Ausnehmung einen im Wesentlichen runden Querschnitt auf. Sie kann als ein in der zweiten Elektrode vorgesehener Durchbruch ausgeführt sein. In diesem Fall kann der Heizleiter durch den Durchbruch hindurch geführt sein.

Nach einer weiteren Ausgestaltung kann es sein, dass das Gewicht zylindrisch ausgebildet ist. In diesem Fall ist es zweckmäßig, dass ein Außendurchmesser des Gewichts kleiner als ein Innendurchmesser der Ausnehmung ist. Dann kann beispielsweise auch das Gewicht in der Ausnehmung geführt sein.

Grundsätzlich wird es nach dem Gegenstand der vorliegenden Erfindung als vorteilhaft angesehen, eine Biegung des Heizleiters im Bereich der zweiten Elektrode möglichst gering zu halten. Der Vektor der Gewichtskraft bildet zweckmäßigerweise mit der Richtung der Längserstreckung des Heizleiters einen Winkel von 5 bis 35°, vorzugsweise von 10 bis 20°.

Nach einer weiteren vorteilhaften Ausgestaltung ist vorgesehen, dass zwei benachbarte Heizleiter aus einem einzigen Draht gebildet sind, der im Bereich der ersten Elektrode umbiegt und im Bereich der zweiten Elektrode an seinen beiden Enden mit jeweils einem Gewicht versehen ist. Beispielsweise kann der Draht durch zwei benachbarte weitere Durchbrüche an der ersten Elektrode hindurchgeführt werden. Die beiden Enden des Drahts können sodann durch beispielsweise an der zweiten Elektrode vorgesehene Durchbrüche durchgeführt und an den über die zweite Elektrode hinausstehenden Enden jeweils mit einem Gewicht versehen sein. Anstelle der vorgenannten Durchbrüche können selbstverständlich auch schlitzartige Ausnehmungen vorgesehen sein.

Nach einer weiteren Ausgestaltung sind die Heizleiter aus einem Refraktärmetall, vorzugsweise aus W, Ta, Mo, Rh oder einer Legierung davon, hergestellt. Die vorgeschlagenen Materialien eignen sich einerseits zur Herstellung besonders dünner Drähte und können andererseits hohen thermischen Belastungen ausgesetzt werden.

Die Heizleiter sind zweckmäßigerweise Drähte mit einem Durchmesser im Bereich von 5 µm bis 500 µm, vorzugsweise im Bereich von 100 µm bis 300 µm. Insbesondere bei Verwendung von Heizleitern mit einem kleinen Durchmesser kann die erforderliche elektrische Leistung zur Beschichtung eines Substrats erheblich reduziert werden. Gleichzeitig kann eine hohe Temperatur des Heizleiters erreicht werden, wodurch die Bildung atomaren Wasserstoffs unterstützt wird.

Die Heizleiter müssen nicht unbedingt in Form von Drähten ausgestaltet sein. Es kann auch sein, dass es sich dabei um Bänder, Stangen oder Bleche handelt. Ein Durchmesser oder eine Querschnittsfläche der Heizleiter muss nicht über deren gesamte Längserstreckung gleich sein.

Nach einer weiteren Ausgestaltung ist an der ersten Elektrode eine Halteeinrichtung zur Befestigung des anderen Endes des Heizleiters vorgesehen. Dabei kann es sich zweckmäßigerweise um eine Einrichtung zur klemmenden Befestigung des Heizleiters handeln. Die Halteeinrichtung kann insbesondere so ausgebildet sein, dass eine Befestigung der Heizleiter ohne eine wesentliche Umbiegung derselben möglich ist.

Bei der erfindungsgemäßen Vorrichtung ist die erste Elektrode oberhalb der zweiten Elektrode angeordnet. Die Heizleiter erstrecken sich im Wesentlichen vertikal zwischen der ersten und der zweiten Elektrode. In einer nicht erfindungsgemäßen Ausführung können sie bezüglich der Vertikalrichtung geringfügig schräg gestellt sein. Ein Schrägstellungswinkel bezüglich der Vertikalrichtung ist üblicherweise ≤ 20°.

Nach einer weiteren Ausgestaltung der Erfindung ist die erste und/oder zweite Elektrode aus einem dispersionsverfestigten Kupferwerkstoff hergestellt. Der vorgeschlagene dispersionsverfestigte Kupferwerkstoff ist auch bei hohen Temperaturen äußerste formstabil. Abgesehen davon können Werkstücke, insbesondere Profile oder Hohlprofile, aus einem solchen Werkstoff einfach und kostengünstig extrudiert und nachfolgend bearbeitet werden.

Vorteilhafterweise ist eine Kühleinrichtung zum Kühlen der ersten und/oder zweiten Elektrode vorgesehen. Zu diesem Zweck können die erste und/oder zweite Elektrode beispielsweise in Form eines Hohlprofils ausgebildet sein, welches mit einem Kühlfluid durchströmt wird. Bei dem Kühlfluid handelt es sich zweckmäßigerweise um Wasser.

Nach einer weiteren vorteilhaften Ausgestaltung ist das Heizleiter-Array als Modul ausgeführt. D. h. die erste und die zweite Elektrode sind relativ zueinander, beispielsweise mittels seitlich angebrachter Stützen, fest verbunden und bilden eine Baueinheit. Eine solche Baueinheit ist zweckmäßigerweise so ausgeführt, dass sie in einem herkömmlichen Gehäuse einer CVD-Beschichtungsvorrichtung angeordnet werden kann.

Nach weiterer Maßgabe der Erfindung ist ein Verfahren zum Beschichten eines Substrats mittels CVD, insbesondere zum Beschichten mit Diamant oder Silizium vorgesehen, wobei unter Verwendung der erfindungsgemäßen Vorrichtung die folgenden Schritte durchgeführt werden:
Evakuieren des Gehäuses;
Erzeugen einer Wasserstoff und einen gasförmigen Kohlenstoffträger enthaltenden reaktiven Gasatmosphäre im Gehäuse;
Aufheizen der Heizleiter von Umgebungstemperatur auf eine Temperatur im Bereich von 1500°C bis 2800°C für eine Haltezeit von 1 bis 100 Stunden;
Evakuieren des Gehäuses;
Abkühlen der Heizleiter auf Umgebungstemperatur.

Beim Evakuieren des Gehäuses wird darin ein Druck im Bereich von etwa 0,1 bis 400 mbar eingestellt. Der Druck beim Erzeugen der reaktiven Gasatmosphäre beträgt 1 bis 400 mbar, vorzugsweise 3 bis 20 mbar. Die reaktive Gasatmosphäre enthält zweckmäßigerweise 90 bis 99,5 Gew.% an Wasserstoff. Zur Herstellung einer Diamantschicht kann als Kohlenstoffträger beispielsweise Methan in einer Konzentration von 0,5 bis 10 Gew.% verwendet werden. Zur Herstellung einer Siliziumschicht kann die reaktive Gasatmosphäre anstelle des gasförmigen Kohlenstoffträgers einen gasförmigen Siliziumträger enthalten. Optional kann die reaktive Gasatmosphäre zusätzlich Stickstoff, Sauerstoff, Phosphor oder borhaltige Gase enthalten.

Die Heizleiter werden zweckmäßigerweise auf eine Temperatur im Bereich von 1800°C bis 2500°C, vorzugsweise 1900°C bis 2300°C, aufgeheizt. Insbesondere bei den angegebenen hohen Temperaturen wird eine Graphitabscheidung auf den Heizleitern aus der Gasphase vermieden. Damit wird gewährleistet, dass insbesondere auch bei hohen Konzentrationen des Kohlenstoffträgers in der Gasphase stets die Erzeugung von atomarem Wasserstoff an den Heizleitern aufrechterhalten bleibt. - Das Abkühlen der Heizleiter auf Umgebungstemperatur findet zweckmäßigerweise im Vakuum statt, d. h. nicht in der reaktiven Gasatmosphäre. Nach dem Abkühlen der Heizleiter auf Umgebungstemperatur wird das Gehäuse belüftet. Nachfolgend werden die beschichteten Substrate entnommen.

Wegen der weiteren Ausgestaltungsmerkmale des Verfahrens wird auf die bereits zur Vorrichtung beschriebenen Merkmale verwiesen, welche sinngemäß auch für das Verfahren angewendet werden können.

Unter Verwendung des erfindungsgemäßen Verfahrens ist es möglich, bis zu 50 Beschichtungsvorgänge nacheinander durchzuführen, ohne dass die Heizleiter ausgewechselt werden müssen. Dabei bleiben die Heizleiter vorteilhafterweise stets gespannt.

Nachfolgend werden Ausführungsbeispiele anhand der Zeichnungen näher erläutert. Es zeigen:
- Fig. 1: eine schematische Ansicht einer ersten Vorrichtung,
- Fig. 2: eine Draufsicht auf das Gewicht gemäß Fig. 1,
- Fig. 3: eine schematische Ansicht einer zweiten Vorrichtung,
- Fig. 4: eine Draufsicht auf das weitere Gewicht gemäß Fig. 3,
- Fig. 5: eine Detailansicht gemäß Fig. 3,
- Fig. 6: eine schematische Detailansicht einer dritten Vorrichtung,
- Fig. 7: eine schematische Ansicht einer vierten Vorrichtung,
- Fig. 8: eine schematische Detailansicht der vierten Vorrichtung,
- Fig. 9: eine schematische Ansicht einer fünften Vorrichtung und
- Fig. 10: eine schematische Schnittansicht einer CVDBeschichtungsvorrichtung.

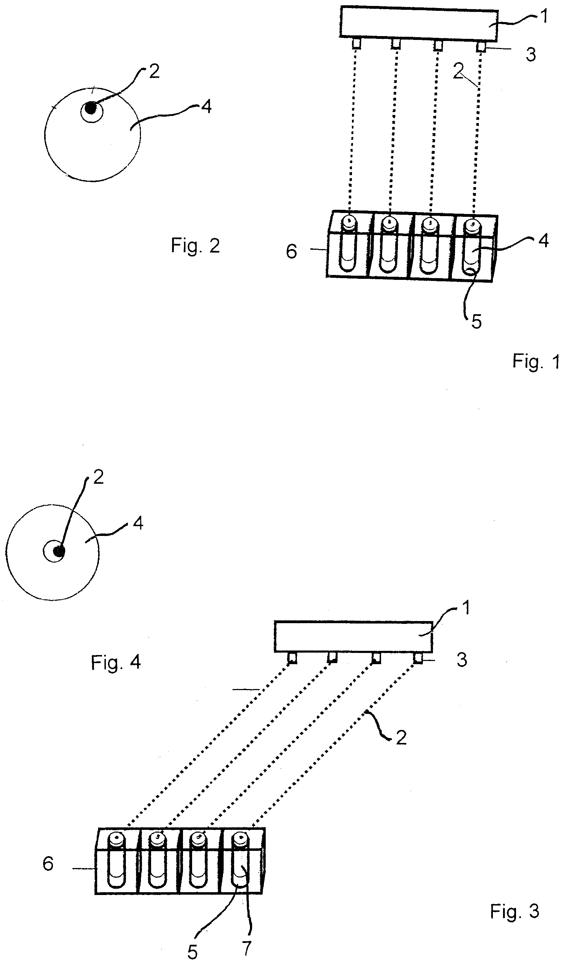

Fig. 1 zeigt eine schematische Ansicht einer ersten Vorrichtung. An einer ersten Elektrode 1 sind in einer Reihe nebeneinander, vorzugsweise mit etwa demselben Abstand, mehrere Heizleiter 2 angebracht. Die Heizleiter 2 können in Haltevorrichtungen 3 klemmend aufgenommen sein, welche an der ersten Elektrode 1 vorgesehen sind. Die Heizleiter 2 werden durch an deren Ende vorgesehene Gewichte 4 individuell gespannt gehalten. Die zylindrisch ausgeführten Gewichte 4 sind in dazu korrespondierenden Ausnehmungen 5 gleitverschiebbar geführt, welche an einer zweiten Elektrode 6 vorgesehen sind. Die zweite Elektrode 6 befindet sich hier unterhalb der ersten Elektrode 1 in einer durch die erste Elektrode 1 verlaufenden vertikalen Ebene. Die Ausnehmungen 5 weisen bezüglich der Gewichte 4 in Axialrichtung eine gerade Kontaktlinie bzw. -fläche auf. Die Halteeinrichtungen 3 an der ersten Elektrode 1 und die Ausnehmungen 5 an der zweiten Elektrode 6 sind so ausgeführt, dass die Heizleiter 2 in einer im Wesentlichen parallelen Anordnung gespannt gehalten werden.

Fig. 2 zeigt eine Draufsicht auf die Gewichte 4 gemäß Fig. 1. Wie aus Fig. 2 ersichtlich ist, sind die Heizleiter 2 außerhalb eines Schwerpunkts der Gewichte 4 angebracht. Infolgedessen ergibt sich ein Kippmoment, welches die Gewichte 4 gegen eine Innenfläche der Ausnehmungen 5 zwingt. Dabei ist das Kippmoment so bemessen, dass zwischen der zweiten Elektrode 6 und den Gewichten 4 bzw. den daran angebrachten Heizleitern 2 ein elektrischer Schleifkontakt gebildet ist. Bei einer thermisch induzierten Änderung der Länge der Heizleiter 2 gleiten die jeweiligen Gewichte 4 geradlinig entlang der Innenfläche der jeweiligen Ausnehmung 5.

Die Fig. 3 und 4 zeigen eine schematische Ansicht einer zweiten Vorrichtung. Die erste 1 und die zweite Elektrode 6 sind in derselben vertikalen Ebene angeordnet. Dabei sind allerdings die an der zweiten Elektrode 6 vorgesehenen Ausnehmungen 5 geringfügig horizontal versetzt zu den Halteeinrichtungen 3 an der ersten Elektrode 1 angeordnet. In diesem Fall können - wie aus Fig. 4 ersichtlich ist - die Heizleiter 2 zentrisch an den zylindrisch ausgebildeten Gewichten 4 angebracht sein. Wegen der versetzten Anordnung der ersten 1 und der zweiten Elektrode 6 wirkt auf die Gewichte 4 wiederum ein Kippmoment, welches eine die Gewichte 4 in Anlage mit einer Innenwand der Ausnehmungen 5 zwingende Kontaktkraft K bewirkt. Auch hier ist die Kontaktkraft K so gewählt, dass eine durch thermische Längenänderungen der Heizleiter 2 bedingte Vertikalbewegung der Gewichte 4 innerhalb der Ausnehmung 5 jederzeit möglich ist und die Heizleiter 2 immer gespannt gehalten werden. Auch hier werden die Gewichte 4 im Falle einer thermischen Längenänderung der Heizleiter 2 an der Innenwand der Ausnehmungen 5 auf einer geradlinig ausgebildeten Kontaktlinie bzw. -fläche bewegt. Eine solche geradlinige Ausbildung der Kontaktfläche zwischen dem Gewicht 4 und der zweiten Elektrode 6 trägt zu besonders geringen Reibungsverlusten bei. Die Heizleiter 2 können damit jederzeit straff gespannt gehalten werden.

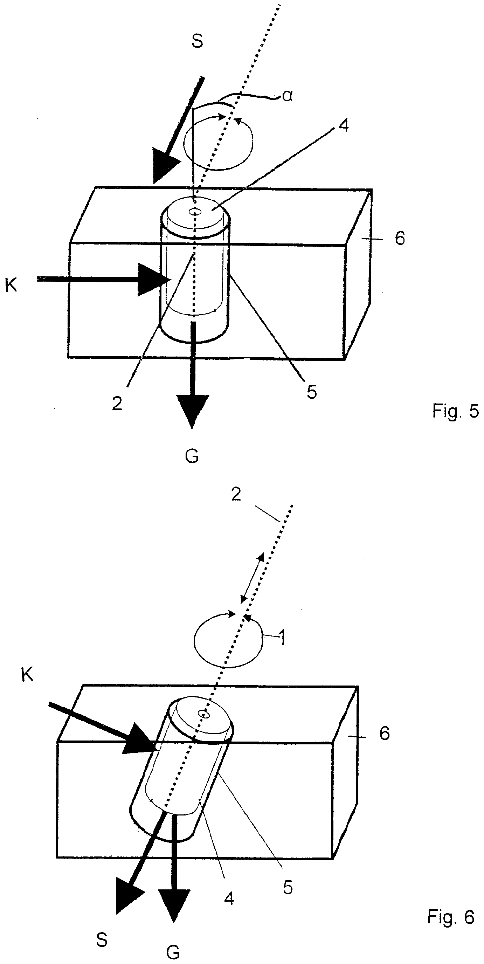

Fig. 5 zeigt eine Detailansicht gemäß Fig. 3. Daraus ist ersichtlich, dass ein Vektor einer auf den Heizleiter 2 wirkenden Spannkraft S parallel zur Richtung der Längserstreckung des Heizleiters 2 verläuft. Ein Vektor einer durch das Gewicht 4 erzeugten Gewichtskraft G verläuft dagegen immer vertikal. Mit α ist ein Winkel zwischen der Längserstreckung des Heizleiters 2 und dem Vektor der Gewichtskraft G bezeichnet. Unter dem Begriff "Längserstreckung" wird im Sinne der vorliegenden Erfindung eine Richtung verstanden, welche der Heizleiter 2 von der ersten 1 zur zweiten Elektrode 6 beschreibt.

Mit K ist ein senkrecht zum Vektor der Gewichtskraft G verlaufender Vektor einer Kontaktkraft bezeichnet, mit welcher das Gewicht 4 gegen die Innenwand der Ausnehmung 5 gezwungen wird. Die Kontaktkraft K ist abhängig vom Winkel α sowie von der Gewichtskraft G. Der Winkel α wird zweckmäßigerweise in einem Bereich von 10 bis 20° gewählt. Bei dieser Ausgestaltung erfolgt eine Bewegung des im Schleifkontakt befindlichen Gewichts 4 geradlinig und parallel zum Vektor der Gewichtskraft G.

Fig. 6 zeigt eine Detailansicht einer dritten Vorrichtung. Dabei verläuft eine Achse der hier wiederum zylindrisch ausgebildeten Ausnehmung 5 parallel zur Richtung der Längserstreckung des Heizleiters 2. In diesem Fall steht der Vektor der Kontaktkraft K senkrecht auf dem Vektor der Spannkraft S. Auch hier wird das Gewicht 4 gegen die Innenwand der Ausnehmung 5 gezwungen, so dass mit dem Gewicht 4 einerseits der Heizleiter 2 gespannt gehalten und andererseits ein elektrischer Schleifkontakt hergestellt wird. Das Gewicht 4 bewegt sich dabei geradlinig entlang der Kontaktfläche.

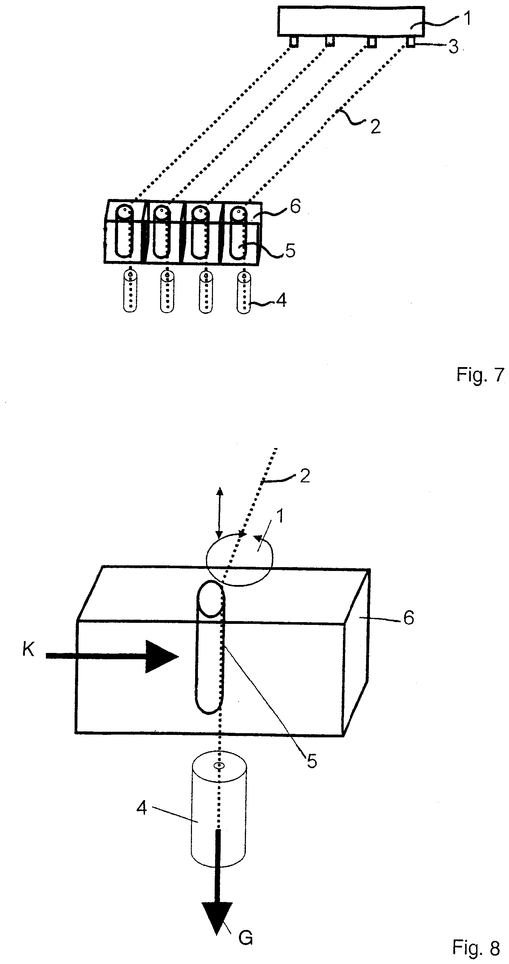

Die Fig. 7 und 8 zeigen eine vierte Vorrichtung. Dabei sind die Ausnehmungen 5 an der zweiten Elektrode 6 in Form von Durchbrüchen ausgeführt. Die Halteeinrichtungen 3 an der ersten Elektrode 1 sind wiederum versetzt zu den korrespondierenden Ausnehmungen 5 angeordnet, so dass die Heizleiter 2 zwischen der ersten Elektrode 1 und der zweiten Elektrode 6 nicht vertikal, sondern in einer von der vertikalen Richtung geringfügig abweichenden Schrägrichtung gespannt gehalten werden. Die Heizleiter 2 sind durch die an der zweiten Elektrode 6 vorgesehenen Durchbrüche 5 hindurchgeführt. Die Gewichte 4 sind hier jeweils unterhalb der zweiten Elektrode 6 an den freien Enden der Heizleiter 2 angebracht. Eine Kontaktlinie bzw. -fläche zwischen dem Heizleiter 2 und der Ausnehmung 5 ist auch hier geradlinig ausgebildet. Das erhöht die Haltbarkeit der Heizleiter 2. Gleichzeitig wird ein Reibungswiderstand beim Ausgleich thermisch induzierter Längenänderungen der Heizleiter 2 vermindert.

Wie aus Fig. 8 ersichtlich ist, ergibt sich bei dieser Anordnung eine auf den Heizleiter 2 senkrecht zur Gewichtskraft G wirkende Kontaktkraft K, welche den Heizleiter 2 gegen die Innenwand des Durchbruchs 5 zwingt. Hier wird der elektrische Schleifkontakt also unmittelbar zwischen dem Heizleiter 2 und der zweiten Elektrode 6 gebildet.

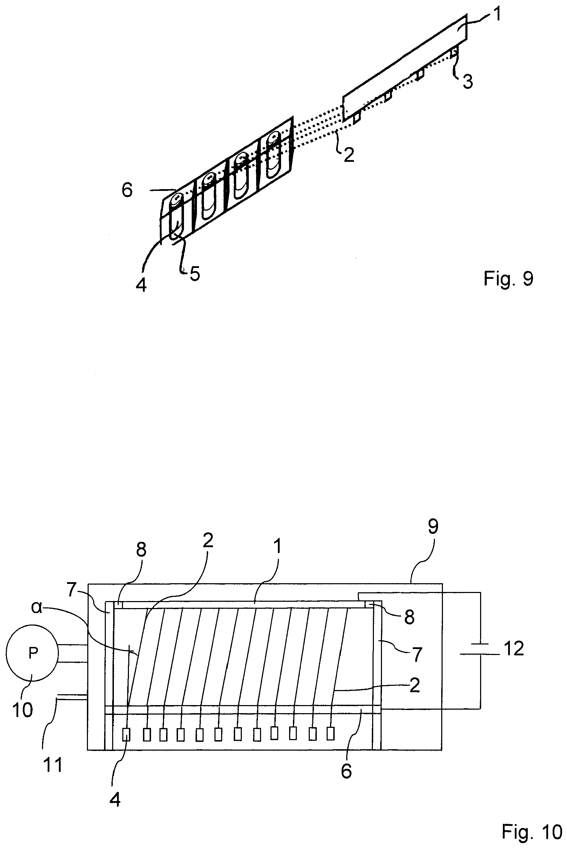

Fig. 9 zeigt eine schematische Darstellung einer fünften Vorrichtung. Dabei ist die erste Elektrode 1 zwar oberhalb der zweiten Elektrode 6, jedoch nicht in derselben vertikalen Ebene wie die zweite Elektrode 6 angeordnet. D. h. die an der ersten Elektrode 1 vorgesehenen Halteeinrichtungen 3 sind zu den dazu korrespondierenden Ausnehmungen 5 an der zweiten Elektrode 6 so versetzt, dass die Heizleiter 2 nicht in einer vertikalen Ebene, sondern schräg im Raum angeordnet sind. Ein Schrägstellungswinkel der Heizleiter 2 bezüglich der vertikalen Richtung beträgt dabei zweckmäßigerweise weniger als 45°, vorzugsweise weniger als 30°. Auch in diesem Fall ergibt sich - ähnlich wie bei dem in Fig. 5 gezeigten Ausführungsbeispiel - eine Kontaktkraft K, welche die Gewichte 4 gegen die Innenfläche der Ausnehmungen 5 zwingt. Mit der vorgeschlagenen Anordnung der Heizleiter 2 in einer schrägen Ebene kann bei einer relativ dazu horizontalen Anordnung der zu beschichtenden Substrate eine zu- oder abnehmende Schichtdicke auf den Substraten realisiert werden.

Fig. 10 zeigt eine schematische Ansicht einer CVD-Beschichtungsvorrichtung. Dabei sind die erste 1 und die zweite Elektrode 6 über Stützen 7 und unter Zwischenschaltung elektrischer Isolationsmittel 8 miteinander verbunden. Sie bilden hier zusammen mit den daran angebrachten Heizleitern 2 ein Heizleiter-Array, welches in einem gasdichten Gehäuse 9 aufgenommen ist. Zum Evakuieren des Gehäuses 9 ist eine Pumpe 10 vorgesehen. Mit dem Bezugszeichen 11 ist ein Stutzen bezeichnet, durch den wahlweise Reaktionsgas in das Gehäuse 9 geführt werden kann. Die erste 1 und die zweite Elektrode 6 sind zum Beheizen der Heizleiter 2 mit einer Stromquelle 12 verbunden.

### Bezugszeichenliste

- 1: erste Elektrode
- 2: Heizleiter
- 3: Halteeinrichtung
- 4: Gewicht
- 5: Ausnehmung
- 6: zweite Elektrode
- 7: Stütze
- 8: elektrisches Isolationsmittel
- 9: Gehäuse
- 10: Pumpe
- 11: Stutzen
- 12: Stromquelle

- α: Winkel
- G: Gewichtskraft
- K: Kontaktkraft
- S: Spannkraft

## Patentansprüche

1. Vorrichtung zum Beschichten eines Substrats mittels CVD, insbesondere zum Beschichten mit Diamant oder Silizium,
wobei in einem Gehäuse (9) ein Heizleiter-Array aus einer Vielzahl sich in einer Längserstreckungsrichtung von einer ersten (1) zu einer zweiten Elektrode (6) erstreckenden Heizleitern (2) vorgesehen ist, wobei die erste Elektrode (1) oberhalb der zweiten Elektrode (6) in einer durch die erste Elektrode (1) verlaufenden vertikalen Ebene angeordnet ist,
**dadurch gekennzeichnet,**
**dass** die Heizleiter (2) durch ein an deren einem Ende angebrachtes Gewicht (4) individuell gespannt gehalten werden,
und **dass** das Gewicht (4) oder der Heizleiter (2) an der zweiten Elektrode (6) unter Ausbildung eines elektrischen Schleifkontakts so geführt ist, dass ein Vektor der durch das Gewicht (4) erzeugten Gewichtskraft (G) mit der Längserstreckungsrichtung des Heizleiters (2) einen Winkel (α) von 5 bis 35° bildet.

2. Vorrichtung nach Anspruch 1, wobei eine den Heizleiter (2) oder das Gewicht (4) gegen die zweite Elektrode (6) zwingende Kontaktkraft (K) vom Winkel (α) und der durch das Gewicht (4) hervorgerufen Gewichtskraft (G) abhängig ist.

3. Vorrichtung nach einem der vorhergehenden Ansprüche, wobei das Gewicht (4) oder der Heizleiter (2) gleitverschiebbar an einer Innenwand einer an der zweiten Elektrode (6) vorgesehenen Ausnehmung (5) anliegen.

4. Vorrichtung nach einem der vorhergehenden Ansprüche, wobei die Ausnehmung (5) einen im Wesentlichen runden Querschnitt aufweist.

5. Vorrichtung nach einem der vorhergehenden Ansprüche, wobei die Ausnehmung (5) ein in der zweiten Elektrode (6) vorgesehener Durchbruch oder eine schlitzartige Ausnehmung ist.

6. Vorrichtung nach einem der vorhergehenden Ansprüche, wobei der Heizleiter (2) durch den Durchbruch hindurch geführt ist.

7. Vorrichtung nach einem der vorhergehenden Ansprüche, wobei das Gewicht (4) zylindrisch ausgebildet ist.

8. Vorrichtung nach einem der vorhergehenden Ansprüche, wobei ein Außendurchmesser des Gewichts (4) kleiner als ein Innendurchmesser der Ausnehmung (5) ist.

9. Vorrichtung nach einem der vorhergehenden Ansprüche, wobei der Vektor der Gewichtskraft (G) mit der Richtung der Längserstreckung des Heizleiters (2) einen Winkel (α) von 10 bis 20° bildet.

10. Vorrichtung nach einem der vorhergehenden Ansprüche, wobei zwei benachbarte Heizleiter (2) aus einem einzigen Draht gebildet sind, der im Bereich der ersten Elektrode (1) umbiegt und im Bereich der zweiten Elektrode (6) an seinen beiden Enden mit jeweils einem Gewicht (4) versehen ist.

11. Vorrichtung nach einem der vorhergehenden Ansprüche, wobei die Heizleiter (2) aus einem Refraktärmetall, vorzugsweise aus W, Ta, Mo, Rh oder einer Legierung davon, hergestellt sind.

12. Vorrichtung nach einem der vorhergehenden Ansprüche, wobei die Heizleiter (2) einen Durchmesser von 5 bis 500 µm, vorzugsweise von 100 bis 300 µm, aufweisen.

13. Vorrichtung nach einem der vorhergehenden Ansprüche, wobei die erste (1) und/oder zweite Elektrode (6) aus einem dispersionsverfestigten Kupferwerkstoff hergestellt ist.

14. Vorrichtung nach einem der vorhergehenden Ansprüche, wobei eine Kühleinrichtung zum Kühlen der ersten (1) und/oder zweiten Elektrode (6) vorgesehen ist.

15. Vorrichtung nach einem der vorhergehenden Ansprüche, WObei das Heizleiter-Array als Modul ausgeführt ist.

16. Verfahren zum Beschichten eines Substrats mittels CVD, insbesondere zum Beschichten mit Diamant oder Silizium, wobei unter Verwendung einer Vorrichtung nach einem der vorhergehenden Ansprüche die folgenden Schritte durchgeführt werden:
Evakuieren des Gehäuses (9);
Erzeugen einer Wasserstoff und einen gasförmigen Kohlenstoff- oder Siliziumträger enthaltenden reaktiven Gasatmosphäre im Gehäuse (9);
Aufheizen der Heizleiter (2) von Umgebungstemperatur auf eine Temperatur im Bereich von 1500°C bis 2800°C für eine Haltezeit von 1 bis 100 Stunden;
Evakuieren des Gehäuses (9);
Abkühlen der Heizleiter (2) auf Umgebungstemperatur.

17. Verfahren nach Anspruch 16, wobei die reaktive Gasatmosphäre Bor und/oder Phosphor enthält.

## Claims

1. Device for coating a substrate using CVD, in particular for coating with diamond or silicon,
wherein a heating conductor array composed of a plurality of heating conductors (2) extending in a longitudinal extension direction from a first (1) to a second electrode (6) is provided in a housing (9),
wherein the first electrode (1) is located above the second electrode (6) at a vertical plane running through the first electrode (1),
**characterized in that**
the heating conductors (2) are individually held taut by a weight (4) mounted on their one end,
wherein the weight (4) or the heating conductor (2) is guided at the second electrode (6) forming an electrical sliding contact in such a manner that a vector of the weight force (G) created by the weight (4) forms an angle (α) of 5° to 35° with the longitudinal extension direction of the heating conductor (2).

2. Device as defined in claim 1, wherein a contact force (K) forcing the heating conductor (2) or the weight (4) against the second electrode (6) depends on the weight force (G) caused by the weight (4).

3. Device as defined in one of the preceding claims, wherein the weight (4) or the heating conductor (2) abut in a slidably displaceable manner on an interior wall of a recess (5) provided on the second electrode (6).

4. Device as defined in one of the preceding claims, wherein the recess (5) has an essentially round cross section.

5. Device as defined in one of the preceding claims, wherein the recess (5) is a breakthrough provided in the second electrode (6) or a recess with the shape of a slit.

6. Device as defined in one of the preceding claims, wherein the heating conductor (2) is guided through the breakthrough.

7. Device as defined in one of the preceding claims, wherein the weight (4) is designed cylindrically.

8. Device as defined in one of the preceding claims, wherein an outer diameter of the weight (4) is less than an inner diameter of the recess (5).

9. Device as defined in one of the preceding claims, wherein the vector of the weight force (G) forms an angle (α) of 10° to 20° with the direction of the longitudinal extension of the heating conductor (2).

10. Device as defined in one of the preceding claims, wherein two adjacent heating conductors (2) are made of a single wire which bends around in the area of the first electrode (1) and is provided on each of its two ends with a weight (4) in the area of the second electrode (6).

11. Device as defined in one of the preceding claims, wherein the heating conductors (2) are made of a refractory metal, preferably of W, Ta, Mo, Rh or an alloy thereof.

12. Device as defined in one of the preceding claims, wherein the heating conductors (2) have a diameter of 5 to 500 µm, preferably of 100 to 300 µm.

13. Device as defined in one of the preceding claims, wherein the first (1) and/or second electrode (6) is made of a dispersion-strengthened copper material.

14. Device as defined in one of the preceding claims, wherein a cooling unit is provided for cooling the first (1) and/or second electrode (6).

15. Device as defined in one of the preceding claims, wherein the heating conductor array is designed as a module.

16. Method for coating a substrate using CVD, in particular for coating with diamond or silicon, wherein using a device as defined in one of the preceding claims, the following steps are performed:
Evacuating the housing (9);
Generating a reactive gaseous atmosphere containing hydrogen and a gaseous carbon or silicon carrier in the housing (9);
Heating up the heating conductors (2) from the ambient temperature to a temperature ranging from 1500° C to 2800° C for a holding time of 1 to 100 hours;
Evacuating the housing (9);
Cooling off the heating conductors (2) to the ambient temperature.

17. Method as defined in claim 16, wherein the reactive gaseous atmosphere contains boron and/or phosphorus.

## Revendications

1. Dispositif pour revêtir un substrat par dépôt chimique en phase vapeur (CVD), en particulier pour le revêtir de diamant ou de silicium,
en ce qu'un agencement de conducteurs chauffants constitué d'une pluralité de conducteurs chauffants (2) s'étendant dans une direction longitudinale entre une première (1) et une deuxième électrode (6), est prévu dans un boîtier (9), en ce que la première électrode (1) au-dessus de la deuxième électrode (6) est disposée dans un plan vertical passant par la première électrode (1),
**caractérisé en ce que**
les conducteurs chauffants (2) sont maintenus tendus individuellement par un poids (4) monté à l'une de leurs extrémités,
et **en ce que** le poids (4) ou le conducteur chauffant (2) est guidé sur la deuxième électrode (6) en réalisant un contact frottant électrique de telle sorte qu'un vecteur de la force de pesanteur (G) générée par le poids (4) forme avec la direction longitudinale du conducteur chauffant (2) un angle (α) de 5 à 35°.

2. Dispositif selon la revendication 1, en ce qu'une force de contact (K) forçant le conducteur chauffant (2) ou le poids (4) contre la deuxième électrode (6) est dépendante de l'angle (α) et de la force de pesanteur (G) causée par le poids (4).

3. Dispositif selon l'une des revendications précédentes, en ce que le poids (4) ou le conducteur chauffant (2) est appliqué de manière déplaçable par glissement sur une paroi intérieure d'un évidement (5) prévu sur la deuxième électrode (6).

4. Dispositif selon l'une des revendications précédentes, en ce que l'évidement (5) présente une section transversale sensiblement ronde.

5. Dispositif selon l'une des revendications précédentes, en ce que l'évidement (5) est un passage prévu dans la deuxième électrode (6) ou un évidement en forme de fente.

6. Dispositif selon l'une des revendications précédentes, en ce que le conducteur chauffant (2) est passé à travers le passage.

7. Dispositif selon l'une des revendications précédentes, en ce que le poids (4) est de conception cylindrique.

8. Dispositif selon l'une des revendications précédentes, en ce qu'un diamètre extérieur du poids (4) est inférieur à un diamètre intérieur de l'évidement (5).

9. Dispositif selon l'une des revendications précédentes, en ce que le vecteur de la force de pesanteur (G) forme avec la direction longitudinale du conducteur chauffant (2) un angle (α) de 10 à 20°.

10. Dispositif selon l'une des revendications précédentes, en ce que deux conducteurs chauffants (2) adjacents sont formés d'un seul fil qui se recourbe dans la zone de la première électrode (1) et dans la zone de la deuxième électrode (6) est muni respectivement d'un poids (4) à ses deux extrémités.

11. Dispositif selon l'une des revendications précédentes, en ce que les conducteurs chauffants (2) sont réalisés en un métal réfractaire, de préférence en W, Ta, Mo, Rh ou en un de leur alliage.

12. Dispositif selon l'une des revendications précédentes, en ce que les conducteurs chauffants (2) présentent un diamètre compris entre 5 et 500 µm, de préférence entre 100 et 300 µm.

13. Dispositif selon l'une des revendications précédentes, en ce que la première (1) et/ou la deuxième électrode (6) est réalisée en un alliage de cuivre durci par dispersion.

14. Dispositif selon l'une des revendications précédentes, en ce qu'un dispositif de refroidissement est prévu pour le refroidissement de la première (1) et/ou de la deuxième électrode (6).

15. Dispositif selon l'une des revendications précédentes, en ce que l'agencement de conducteurs chauffants est réalisé sous forme de module.

16. Procédé pour revêtir un substrat par dépôt chimique en phase vapeur (CVD), en particulier pour le revêtir de diamant ou de silicium, en ce que les opérations suivantes sont effectuées en utilisant un dispositif selon l'une des revendications précédentes :
mise sous vide du boîtier (9) ;
production d'une atmosphère gazeuse réactive contenant de l'hydrogène et un porteur de carbone ou de silicium gazeux dans le boîtier (9) ;
mise en température des conducteurs chauffants (2) de la température ambiante à une température comprise entre 1500 °C et 2800 °C pour un temps de maintien de 1 à 100 heures ;
mise sous vide du boîtier (9) ;
refroidissement des conducteurs chauffants (2) à la température ambiante.

17. Procédé selon la revendication 16, en ce que l'atmosphère gazeuse réactive contient du bore et/ou du phosphore.
